# EUROPEAN PATENT SPECIFICATION

(11) **EP 0 284 498 B1**
(45) Date of publication and mention of the grant of the patent: **28.12.1994**
(21) Application number: 88400633.9
(22) Date of filing: 16.03.1988
(51) Int. Cl.: G01R 23/10

(54) **Frequency counter in particular for counting partly varying frequencies in real time**
Frequenzzähler, insbesondere zur Echtzeitzählung von teilweise veränderlichen Frequenzen
Compteur de fréquence, en particulier pour compter en temps réel des fréquences en partie variable

(30) Priority: 16.03.1987 JP 60417/87
(43) Date of publication of application: 28.09.1988
(73) Proprietor: FUJITSU LIMITED, Kawasaki-shi, Kanagawa 211 (JP)
(72) Inventor: Abe, Yoshitaka, Kawasaki-shi Kanagawa 211 (JP); Murakami, Keiichi, Kawasaki-shi Kanagawa 214 (JP)
(74) Representative: Joly, Jean-Jacques

(56) References cited:
- EP-A- 0 087 025
- GB-A- 2 029 657
- US-A- 3 521 176
- US-A- 3 548 183
- US-A- 3 603 769
- US-A- 3 924 183

## Description

### BACKGROUND OF THE INVENTION

The present invention relates to a frequency counter for counting a frequency and particularly for counting in real time signal frequencies partly varying as a function of time.

In the recent science and engineering field, there are many cases where significant information is obtained from frequency variation of a signal. For example, in ultrasonics, frequencies of echo signals obtained by reflected ultrasound waves from targets located along the transmission direction of a bursted ultrasound wave are varied because of characteristics of the targets. In other words, the characteristic of a target can be studied by counting the frequency variation of the ultrasound echo signal from this target. The same advantage can be obtained in other cases such as in Doppler effect applications, where the frequency variation provides information on the movement of a target.

In such cases, if the frequency variation can be counted in real time, additional advantages are obtained. For instance, in the case of ultrasonics, if the frequency variation due to the target characteristic is counted in real time, quick target response to, for example, some action added to the target may be analyzed, and from which new information on the target characteristic can be studied. In the case of Doppler effect, quick movement of the target can be studied more precisely. However, in the prior art, counting of frequency variation in real time is not easily performed.

An example of a frequency counter can be found in patent document US-A-3,603,769, which discloses an apparatus for monitoring e.g. the human heart rate so as to provide a count value averaged over a predetermined interval immediately preceding the count given. The apparatus records the count data on a looped magnetic track in which cooperating read and write heads are angularly separated so as to provide a write-read time lag corresponding to the above-mentioned interval.

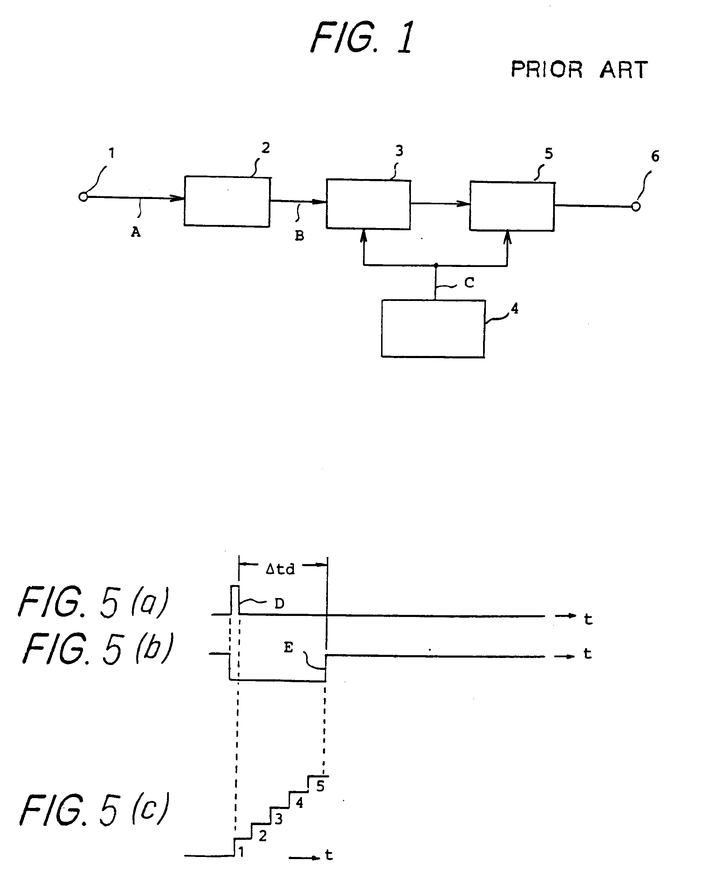

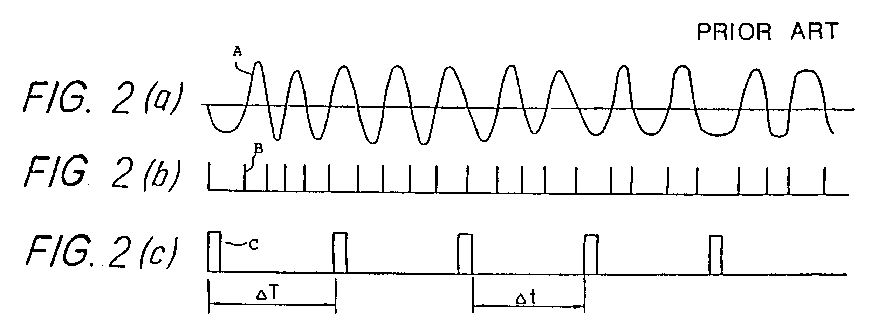

Fig. 1 is a block diagram of a frequency counter of the prior art, and Figs. 2(a), 2(b) and 2(c) show typical waveforms of the signals at circuit points A, B and C of Fig. 1. In Fig. 1, an input signal A received at an input terminal 1 is fed to a zero-crossing detecting circuit 2 which delivers a zero-crossing signal B as shown in Fig. 2(b). The zero-crossing signal B is fed to a counter 3 for counting the number of pulses in the zero-crossing signal B during a time interval Δt. The counter 3 is cleared every time a synchronizing signal C, generated by a synchronizing signal generator 4, is applied to the counter 3, and thereafter counts the number of pulses received until the next synchronizing signal C is received causing the counter 3 to be cleared. The synchronizing signal is in the form of a train of positive narrow pulses having a time period ΔT. The output signal from the counter 3 is received by a latch circuit 5 in which the output signal is latched until the counter 3 is cleared by the succeeding clear pulse, so that the numbers of the zero-crossing signals in every interval Δt is available at output terminal 6, Δt being the time interval between the trailing edge of a synchronizing pulse and the leading edge of the succeeding one.

As seen from the above, in the prior art, the frequency is obtained from the number of zero-crossings in the interval Δt. Therefore, it is impossible to provide a measure of the frequency in real time if the frequency varies within the interval Δt.

If a partly varied frequency of the zero-crossing signal in the interval Δt is attempted to be counted by the prior art frequency counter forcibly, the period Δt must be decreased to, for example, ΔT′ so that the varied frequency can be counted partly. However, in this case, frequency counters as many as the number of ΔT/ΔT′ must be provided in parallel, this being actually hard to realize. This has been also a problem in the prior art.

Another known circuit for monitoring pulses over preset periods is disclosed in GB-A- 2029657. The circuit includes a pulse counter that delivers a count value as n-bit parallel output signals, and an nxk bit shift register successively loading these output signals at each of the preset periods. A timing control circuit is made to provide timing pulses for shifting the register contents and to subsequently clear the counter.

### SUMMARY OF THE INVENTION

An object of the present invention is to count not only an average signal frequency in a counting interval but also a partly varied signal frequency.

Another object of the present invention is to count the partly varied signal frequency in real time.

Yet another object of the present invention is to count the partly varied signal frequency in a single way and using low cost equipment.

The above objects are accomplished by a frequency counter as defined in claim 1.

When the predetermined time period is set at a relatively long value, the average signal frequency can be counted, and when it is set at a relatively short value compared with a variation interval of the partly varied frequency, the partly varied frequency of the input signal can be counted in real time.

### BRIEF DESCRIPTION OF THE DRAWINGS

Fig. 1 is a block diagram of the prior art frequency counter ;
Fig. 2(a) is an input signal to be counted by the prior art frequency counter of Fig. 1 ;
Fig. 2(b) is a zero-crossing signal derived from the input signal to be counted by the prior art frequency counter of Fig. 1 ;
Fig. 2(c) is a synchronizing signal for counting the pulses of the zero-crossing signal in the prior art frequency counter of Fig. 1 ;
Fig. 3 is a block diagram illustrating the principle of a frequency counter according to the present invention ;
Fig. 4 is a block diagram illustrating an embodiment of a frequency counter according to the present invention ;
Fig. 5(a) illustrates the waveform of a clear pulse generated in the frequency counter of Fig. 4 ;
Fig. 5(b) illustrates the waveform a mask signal generated in the frequency counter of Fig. 4 ;
Fig. 5(c) shows the counting of the number of the zero-crossings in the input signal in the frequency counter of Fig. 4 ;
Fig. 6 is a block diagram of an up-down counter forming part of the difference detecting circuit in the frequency counter of Fig. 4 ;
Fig. 7(a) illustrates the waveform of a clear pulse ;
Fig. 7(b) illustrates the waveform of a mask signal ;
Fig. 7(c) is a timing chart showing the zero-crossing pulses relative to the input signal; and
Fig. 7(d) is a timing chart showing the zero-crossing pulses relative to the delayed input signal.

### DESCRIPTION OF THE PREFERRED EMBODIMENTS

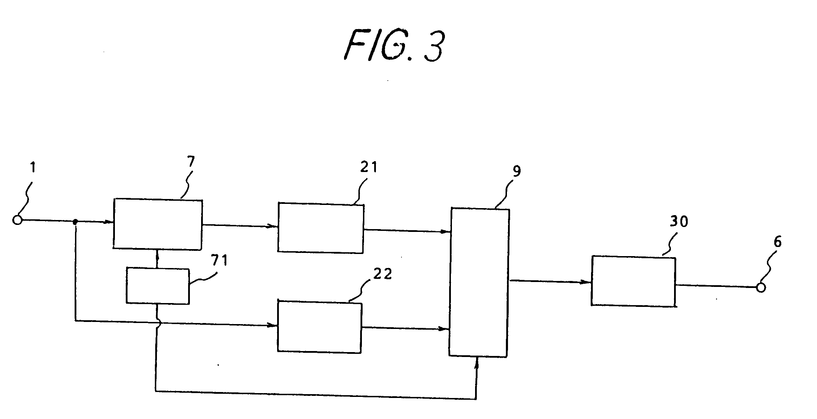

The principle of the present invention will be explained referring to Fig. 3. In Figs. 1 and 3, a same reference numeral designates a same block or part. An input signal, whose frequency is intended to be counted, is received at an input terminal 1 and is fed to a delay circuit 7 and to a zero-crossing detecting circuit 22. In the delay circuit 7, the input signal is delayed by a time period t_{d} whose duration is previously selected by switching a delay time selector 71. The delay time t_{d} is set to be longer than a half period of the signal, in other words, a period of the zero-crossing pulses. When the delay time t_{d} is set to be long, the average frequency of the input signal can be counted, and when it is set to be short compared with the variation interval of the partly varied frequency, the partly varied frequency of the input signal can be counted in real time. The delayed output signal from the delay circuit 7 is fed to another zero-crossing detecting circuit 21. The functions of the zero-crossing detecting circuits 21 and 22 are same as the zero-crossing detecting circuit 2 in Fig. 1, and the zero-crossing detecting circuit will be abbreviated as "zero-crossing detector" hereinafter. Both outputs from the zero-crossing detectors 21 and 22 are fed to a difference detecting circuit 9 in which the difference between the pulse numbers in the zero-crossing signal relative to the input signal and the zero-crossing signal (delayed zero-crossing signal) relative to the delayed input signal is counted from moment to moment.

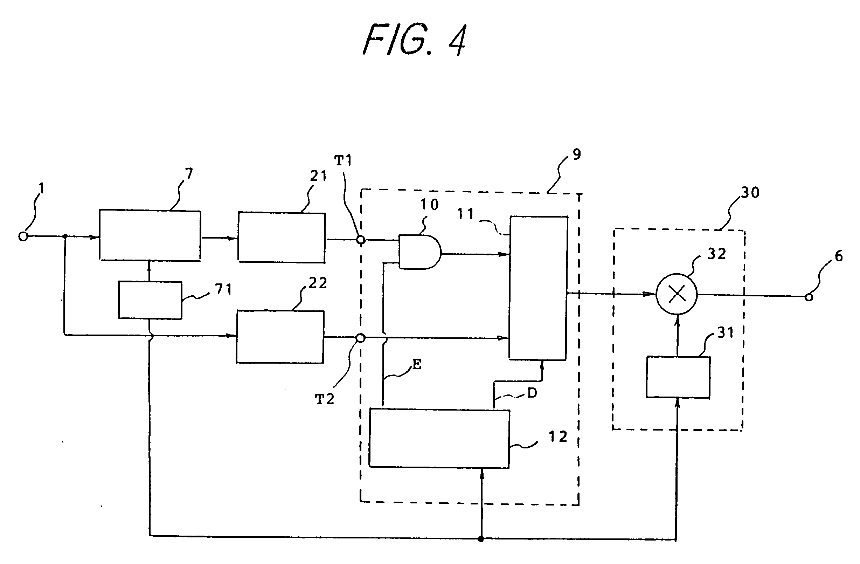

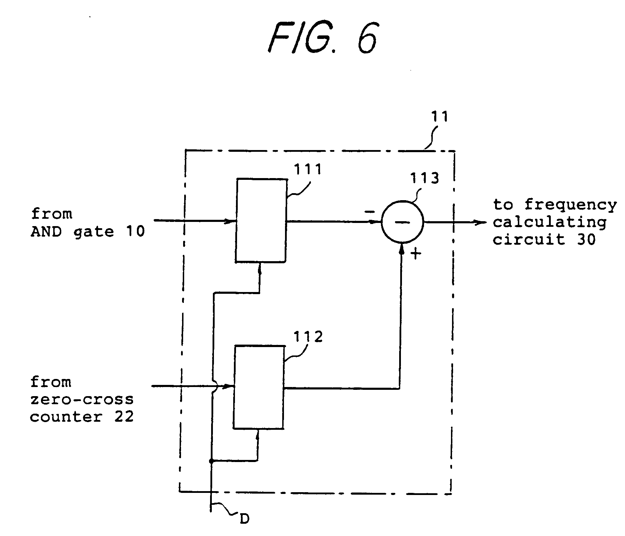

The difference detecting circuit 9 comprises an AND gate 10, a start-up circuit 12 and an up-down counter 11 as shown in Fig. 4. The zero-crossing signals from the zero-crossing detectors 21 and 22 are fed to the difference detecting circuit 9 through terminals T1 and T2 respectively. The start-up circuit 12 produces a clear pulse D and a mask signal E. Figs. 5(a) and 5(b) illustrate the waveforms of the clear pulse D and of the mask signal E, respectively. The mask signal E is applied to one input terminal of AND gate 10 and the pulses of the delayed zero-crossing signal, which are referred to as "delayed zero-crossing pulses" hereinafter, issued from the zero-crossing detector 21 are applied to another input terminal of AND gate 10. The output of the AND gate 10 is connected to an input of up-down counter 11. Thus, the feeding of the delayed zero-crossing pulses from the zero-crossing detector 21 to the up-down counter 11 is prevented as long as the mask signal E is applied to the AND gate 10. Meanwhile, the zero-crossing pulses from the zero-crossing detector 22 are fed directly to another input of the up-down counter 11 connected to terminal T2.

The clear pulse D, shown in Fig. 5(a), is applied to up-down counter 11 for clearing counted numbers in the up-down counter 11. The mask signal E has a negative square waveform and is preset so that it is changed from high to low level in coincidence with the leading edge of clear pulse D and is kept at low level until a time period, equal to the delay time Δt_{d} has elapsed from the trailing edge of clear pulse D. When the clear pulse D is applied to up-down counter 11, the counter 11 is completely cleared before the clear pulse D is over. After the clear pulse D is over, as long as the mask signal E is applied to the AND gate 10, only the zero-crossing pulses from the zero-crossing detector 22 are fed to up-down counter 11, and after the mask signal E is over, the delayed zero-crossing pulses from the zero-crossing detector 21 are fed to up-down counter 11 through AND gate 10.

As shown in Fig. 6, the up-down counter 11 comprises a counter 111, a counter 112 and a subtractor 113. The counters 111 and 112 count the delayed zero-crossing pulses from zero-crossing detector 21 and the zero-crossing pulses from zero-crossing detector 22, respectively. The outputs from the counters 111 and 112 are fed to the subtractor 113 where the number counted by the counter 111 is subtracted from the number counted by the counter 112, in real time.

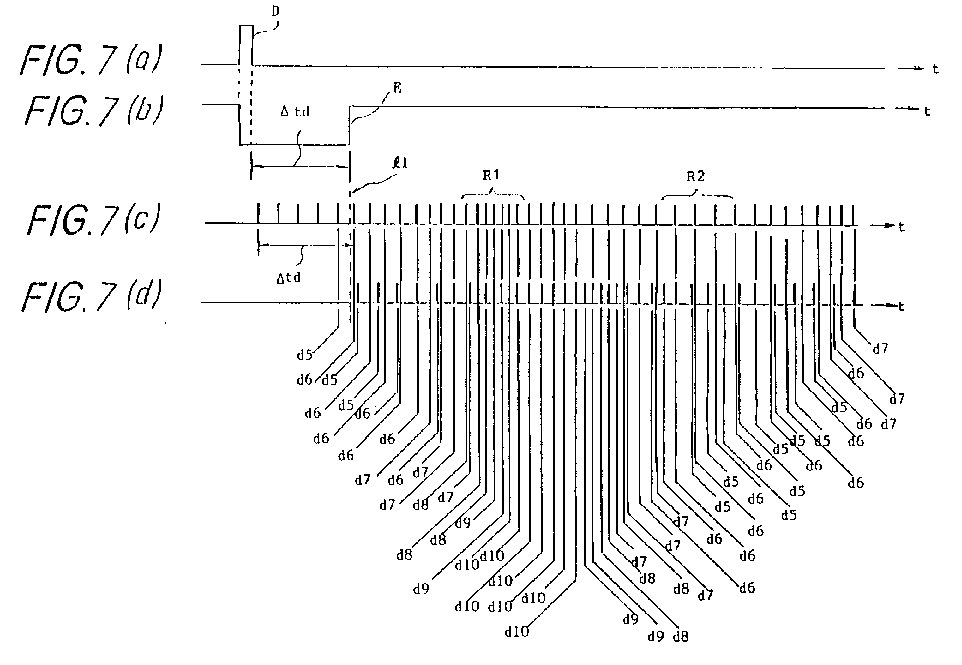

When the clear pulse D is applied to counters 111 and 112, the numbers counted in counters 111 and 112 are cleared. After the clear pulse D is over, the zero-crossing pulses from zero-crossing detector 22 are counted by counter 112 and its output is applied to subtractor 113. However, during application of mask signal E to AND gate 10, counter 111 has no input, so that there is no output from counter 111. In other words, no subtraction is performed by subtractor 113. Accordingly, only the counted output from counter 112 is obtained at the output of subtractor 113 as shown in Fig. 5(c). After the mask signal E is over, the delayed zero-cross pulses from zero-crossing detector 21 are fed to counter 111, so that the counted number of the delayed zero-crossing pulses is subtracted from the counted number of the zero-crossing pulses. As a result, subtractor 113 outputs from time to time a difference between the counted number of the zero-crossing pulses and that of the delayed zero-crossing pulses as shown by Figs. 7(c) and 7(d).

Fig. 7(c) shows the zero-crossing pulses to be counted by the counter 112 and Fig. 7(d) shows the delayed zero-crossing pulses to be counted by counter 111. The numerals, such as d5, d6, --- d10, appearing in Fig. 7(d), indicate the difference output numbers from subtractor 113; for example, d5 indicates that the difference output number is 5.

The operation is as follows. Counters 111 and 112 are cleared by clear pulse D, so that there is no output from the subtractor 113. After clear pulse D is over, counter 112 counts the zero-crossing pulses from zero-crossing detector 22. However, the delayed zero-crossing pulses from zero-crossing detector 21 are not applied to the counter 111. Therefore, the difference output number is only the counted number from counter 112; that is the difference output number is d5 as appearing the left hand side of dotted vertical line l1 in Fig. (7d). After mask signal E is over, the counted number from counter 112 increases to six, so that the difference output number becomes d6. When the first counted number from counter 111 is applied to subtractor 113, the difference output number reduces to d5. Subtractions continue to be carried out from time to time until the next clear pulse D, (not shown in Fig. 7(a)), is applied to difference detecting circuit 9. As a result, a series of difference output numbers, such as d5, d6, d5, ----, d8, d9, d10, d10 ---- d6, d5,----, is obtained as shown in the lower part of Fig. 7(d). It can be seen from said series of difference output numbers that the partly varied frequency of the input signal can be counted in real time. The difference output numbers increase in a first region R1, in which the varying frequency increases, whereas the difference output numbers decrease in a second region R2, in which the varying frequency decreases.

The average frequency and the partly varied frequency of the input signal are counted by frequency calculating circuit 30 (Fig. 4). The frequency calculating circuit 30 comprises a multiplier 32 by which the frequencies are calculated, the partly varied frequency being calculated in real time. A circuit 31 connected to delay time selector 71 is provided for outputting the value of 1/(2 Δt_{d}). The output of circuit 31 is connected to an input of multiplier 32 which has another input connected to the output of up-down counter 11. The average frequency or the partly varied frequency of the input signal is thus counted by means of multiplier 32 by multiplying the difference output number from the subtractor 113 and 1/(2Δt_{d}) together.

## Claims

1. A frequency counter for counting a frequency of an input signal, said frequency counter being responsive to frequency changes in a predetermined time interval and comprising:
delay means (7) for delaying the input signal fed directly thereto, without pre-processing, by said predetermined time and for producing a delayed signal, said predetermined time being selectable so as to be longer than a half period of the input signal;
first detection means (21) for detecting zero crossing pulses of said delayed signal;
second detection means (22) for detecting zero crossing pulses of the input signal;
first count means (111) for counting up the zero crossing pulses of said delayed signal after the predetermined delay time elapses for producing a first count-up output;
second count means (112) for counting up the zero crossing pulses of the input signal from the second zero crossing detection means (22) for producing a second count-up output;
subtraction means (113) for subtracting the value of the first count up output from the value of the second count up output and producing a subtracted output, said subtracted output corresponding to the frequency in said predetermined interval; and
frequency calculating means (30) for calculating the input signal frequency from the difference between said first count-up output and said second count-up output, said frequency calculating means (30) comprising dividing means responsive to said subtracting means (113) and said delay means (7) for dividing said substracted output by twice said delay time, thereby producing a value corresponding to said input signal frequency.

2. A frequency counter according to claim 1, wherein said difference between the first and second count-up outputs is obtained by means comprising:
a start-up circuit (12) for producing a clear pulse (D) and a mask signal (E) having a square waveform, so that a starting edge of said clear pulse coincides (D) with that of said mask signal (E) and said mask signal (E) is terminated just after a time period equal to said predetermined time has elapsed from an ending edge of said clear pulse;
an AND gate (10) receiving said mask signal and said delayed zero-crossing pulses for preventing said delayed zero-crossing pulses from passing through to said first count means (111) as long as said mask signal is applied thereto.

## Patentansprüche

1. Frequenzzähler zum Zählen einer Frequenz eines Eingangssignals, wobei der Frequenzzähler auf Frequenzänderungen in einem vorbestimmten Zeitintervall anspricht und enthält:
Verzögerungseinrichtungen (7) zum Verzögern des direkt darin eingegebenen Eingangssignals, ohne Vorverarbeitung, um die vorbestimmte Zeit und zum Erzeugen eines verzögerten Signals, wobei die vorbestimmte Zeit wählbar ist, so daß sie länger als eine halbe Periode des Eingangssignals ist,
erste Detektionseinrichtungen (21) zum Detektieren von Nulldurchgangsimpulsen des verzögerten Signals,
zweite Detektionseinrichtungen (22) zum Detektieren von Nulldurchgangsimpulsen des Eingangssignals,
erste Zähleinrichtungen (111) zum Aufwärtszählen der Nulldurchgangsimpulse des verzögerten Signals nach Ablauf der vorbestimmten Verzögerungszeit, um eine erste Aufwärtszählausgabe zu erzeugen,
zweite Zähleinrichtungen (112) zum Aufwärtszählen der Nulldurchgangsimpulse des Eingangssignals von den zweiten Nulldurchgangs-Detektionseinrichtungen (22), um eine zweite Aufwärtszählausgabe zu erzeugen,
Subtraktionseinrichtungen (113) zum Subtrahieren des Wertes der ersten Aufwärtszählausgabe vom Wert der zweiten Aufwärtszählausgabe und zum Erzeugen einer Subtraktionsausgabe, wobei die Subtraktionsausgabe der Frequenz in dem vorbestimmten Intervall entspricht, und
Frequenz-Berechnungseinrichtungen (30) zum Berechnen der Eingangssignalfrequenz aus der Differenz zwischen der ersten Aufwärtszählausgabe und der zweiten Aufwärtszählausgabe, wobei die Frequenz-Berechnungseinrichtungen (30) auf die Subtraktionseinrichtungen (113) und die
Verzögerungseinrichtungen (7) ansprechende Divisionseinrichtungen zum Dividieren der Subtraktionsausgabe durch die doppelte Verzögerungszeit enthalten, wodurch ein Wert entsprechend der Eingangssignalfrequenz erzeugt wird.

2. Frequenzzähler nach Anspruch 1, bei dem die Differenz zwischen der ersten und der zweiten Aufwärtszählausgabe durch Einrichtungen erhalten wird, die enthalten:
eine Startschaltung (12) zum Erzeugen eines Löschimpulses (D) und eines Maskensignals (E) mit einer Rechteckimpulsform, so daß eine Startflanke des Löschimpulses (D) mit der des Maskensignals (E) zusammenfällt und das Maskensignal (E) gerade nach Ablauf einer mit der vorbestimmten Zeit übereinstimmenden Zeitperiode von einer Endflanke des Löschimpulses an beendet wird,
ein UND-Gatter (10), das das Maskensignal und die verzögerten Nulldurchgangsimpulse empfängt, um die verzögerten Nulldurchgangsimpulse daran zu hindern, zu den ersten Zähleinrichtungen (111) durchzugehen, so lange das Maskensignal daran anliegt.

## Revendications

1. Compteur fréquencemètre servant à compter la fréquence d'un signal d'entrée, ledit compteur fréquencemètre répondant à des variations de fréquence apparaissant dans un intervalle de temps prédéterminé et comprenant :
un moyen retardateur (7) servant à retarder dudit temps prédéterminé le signal d'entrée qui lui est fourni directement, sans prétraitement, et à produire un signal retardé, ledit temps prédéterminé pouvant être choisi de façon à être plus long qu'une demi-période du signal d'entrée ;
un premier moyen de détection (21) servant à détecter des impulsions de passage par zéro dudit signal retardé ;
un deuxième moyen de détection (22) servant à détecter des impulsions de passage par zéro du signal d'entrée ;
un premier moyen de comptage (111) servant à compter les impulsions de passage par zéro dudit signal retardé après que le temps de retard prédéterminé s'est écoulé afin de produire un premier signal de sortie de comptage ;
un deuxième moyen de comptage (112) servant à compter les impulsions de passage par zéro du signal d'entrée venant du deuxième moyen de détection de passage par zéro (22) afin de produire un deuxième signal de sortie de comptage ;
un moyen de soustraction (113) servant à soustraire la valeur du premier signal de sortie de comptage de la valeur du deuxième signal de sortie de comptage et à produire un signal de sortie soustrait, ledit signal de sortie soustrait correspondant à la fréquence existant dans ledit intervalle prédéterminé ; et
un moyen de calcul de fréquence (30) servant à calculer la fréquence du signal d'entrée à partir de la différence entre ledit premier signal de sortie de comptage et ledit deuxième signal de sortie de comptage, ledit moyen de calcul de fréquence (30) comprenant un moyen de division qui répond audit moyen de soustraction (113) et audit moyen retardateur (7) en divisant ledit signal de sortie soustrait par deux fois ledit temps de retard, de manière à produire une valeur qui correspond à ladite fréquence du signal d'entrée.

2. Compteur fréquencemètre selon la revendication 1, où ladite différence entre les premier et deuxième signaux de sortie de comptage est obtenue par des moyens comprenant :
un circuit de démarrage (12) servant à produire une impulsion d'effacement (D) et un signal de masquage (E) possédant une forme d'onde carrée, de façon que le flanc de départ de ladite impulsion d'effacement (D) coïncide avec celui dudit signal de masquage (E) et que ledit signal de masquage (E) se termine juste après qu'un laps de temps égal audit temps prédéterminé se soit écoulé depuis le flanc terminal de ladite impulsion d'effacement ;
une porte ET (10) recevant ledit signal de masquage et lesdites impulsions de passage par zéro retardées afin d'empêcher que lesdites impulsions de passage par zéro retardées soient transmises audit premier moyen de comptage (111) aussi longtemps que ledit signal de masquage lui est appliqué.
